Europäisches Patentamt

European Patent Office

Office européen des brevets

(11) Publication number: **0 213 820 B1**

# EUROPEAN PATENT SPECIFICATION

(45) Date of publication of patent specification: **09.10.91**

(51) Int. Cl.⁵: **H05K 7/10,** H01R 9/22, H01R 43/16

(21) Application number: **86306160.2**

(22) Date of filing: **08.08.86**

(54) Adaptable terminal assembly for multi-contact electrical connector.

(30) Priority: **12.08.85 JP 122787/85 U**

(43) Date of publication of application:
**11.03.87 Bulletin 87/11**

(45) Publication of the grant of the patent:
**09.10.91 Bulletin 91/41**

(84) Designated Contracting States:
**AT BE CH DE FR GB IT LI LU NL SE**

(56) References cited:
**FR-A- 2 018 767**
**US-A- 3 955 877**

(73) Proprietor: **E.I. DU PONT DE NEMOURS AND COMPANY**
**1007 Market Street**
**Wilmington Delaware 19898(US)**

(72) Inventor: **Takahashi, Fumiyuki**
**201 Corpo-Ogawa 4-19-11, Takashimadaira**
**Itabashi-ku Tokyo(JP)**

(74) Representative: **Barnard, Eric Edward et al**
**BROOKES & MARTIN High Holborn House**
**52/54 High Holborn**
**London WC1V 6SE(GB)**

## Description

### FIELD OF THE INVENTION

The present invention relates to a terminal assembly having a row of terminals supported at a predetermined pitch along one longitudinal side of a terminal carrier.

### BACKGROUND OF THE INVENTION

A terminal assembly, used, for example, to manufacture a multi-contact electrical connector, is generally formed by punching out, at a predetermined pitch non-required portions of a belt-like conductive plate or substrate, leaving a longitudinal region on one side of the substrate substantially intact as a carrier for the terminals thus formed.

In assembling a multi-contact electrical connector, the contact terminals of the terminal assembly are simultaneously set in the housing of a connector while they are still supported by the terminal carrier. Once set, the terminals are then separated from the terminal carrier. Because this particular method of assembly has proven more efficient than that wherein the terminals are separated from the supportive carrier and then set in the housing of the connector individually it is more widely used. This method of assembly, however, necessitates that, even if the terminals are of the shame shape, when two types of connectors with different terminal pitches of e.g. 2.0 mm and 2.54 mm, are required separate terminal assemblies must be prepared to accommodate the different pitches. This problem is common in terminal assemblies for IC pins (IC LEG), IC socket terminals, "Griplet" terminals (trademark of E I DU PONT DE NEMOURS AND COMPANY, U.S.A.)

US-A-3955877 describes a terminal assembly or header stamped or cut from a section of flat stock material and providing a series of spaced-apart terminals along one side of a carrier region which is provided with holes for driving engagement with sprockets as well as V-shaped notches open from one of the major surfaces thereof which provide some flexibility for adjustment of the spacing between the terminals.

### SUMMARY OF THE INVENTION

It is an object of the present invention to provide an improved terminal assembly having a variable terminal pitch.

As is known from US-A3955877, a terminal assembly constructed in accordance with the invention is in the form of a conductive plate with an elongate terminal carrier composed of a series of integral, shaped apertured structures which provide a series of projections arranged at predetermined pitch therealong and a series of terminals supported by the carrier extending from either side of each of the projections along one side of the terminal carrier, the terminals having a pitch corresponding to that of the projections. In accordance with the invention, the plate is flat and the projections are composed of longitudinal sides of the structures which can be subjected to deformation force to cause the projections to move transversally of the carrier to alter the pitch of the terminals.

The projections are usually angular and symmetrical both along the carrier and transverse thereto. To increase the pitch of the terminals the projections can be subjected to uniform compressive force directed inwardly of the carrier.

The structures may be diamond shaped each with four equal sides and two obtuse angles between the sides which form the projections and lozenge shaped holes which are aligned with the centres of the diamond shaped structures. The deformation force closes the openings and lengthens the diamond shaped structures.

The terminal assembly can be made by feeding a conductive metal plate longitudinally in steps of constant predetermined pitch (Da), forming pilot holes in one side margin of the plate with the predetermined pitch (Da), cutting out portions in the side margin of the plate opposite the holes to define projections along one edge of said side margin and terminals with the same predetermined pitch (Da) disposed between the projections and cutting out further portions in the one side margin with the same predetermined pitch (Da) to provide further projections along another edge of the side margin and to create a series of shaped structures defined by the projections which serve as a deformable carrier for the terminals.

In another aspect the invention provides a method of assembling a multi-contact electrical connector, utilizing a terminal assembly as aforesaid, wherein the terminals have a predetermined pitch (Da) and the connector requires contacts with a selectable pitch of at least Da or Db where Db > Da and comprising setting the terminals in a housing of the connector and thereafter separating the terminals from the carrier of the assembly and adjusting the pitch of the terminals, if desired, from Da to Db by subjecting the projections of the carrier to deformation force to cause the projections to move transversally of the carrier prior to setting the terminals in the housing.

The invention may be understood more readily and various other aspects and features of the invention may become apparent from consideration of the following description.

### BRIEF DESCRIPTION OF THE DRAWINGS

An embodiment of the invention will now be described, by way of example only, with reference to the accompanying drawings, wherein:-

Fig. 1 is a perspective view of a terminal assembly constructed in accordance with the present invention;

Fig. 2 is a plan view of the terminal assembly of Fig. 1;

Fig. 3 is a plan view, corresponding to Fig. 2, which shows the terminal assembly after the terminal pitch alteration; and

Figs. 4a to 4c illustrate sequential steps in the manufacture of the terminal assembly of Figs. 1 and 2.

## DETAILED DESCRIPTION OF THE PREFERRED EMBODIMENTS

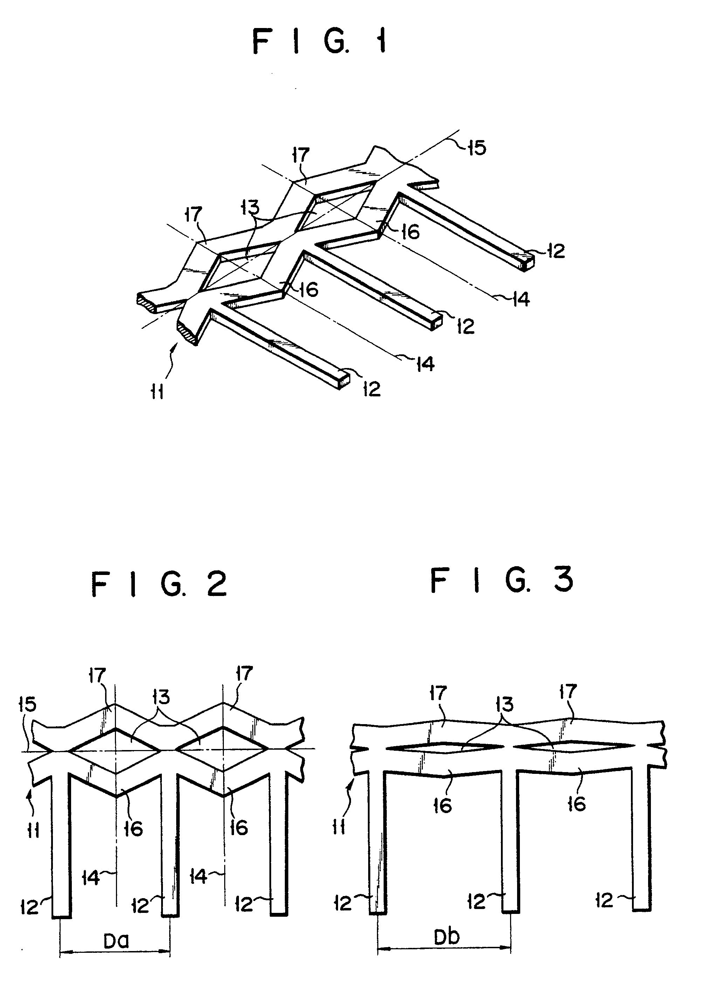

Figs. 1 and 2 depict a terminal assembly produced from a conductive metal strip or plate in a manner described hereinafter. The terminal assembly has a narrow apertured side margin forming a belt-like terminal carrier 11 for a row of spaced terminals 12. The carrier 11 is composed of a series of symmetrical integral, diamond-shaped structures with four equal sides and two obtuse angles whose apices form a series of projections or protuberances arranged at a predetermined pitch Da along the opposite longitudinal sides of the terminal carrier 11. The first projections of the structures at the side of the carrier 11 from which terminals 12 extend are denoted by reference number 16 and the second projections at the opposite side of the carrier 11 are denoted by the reference number 17. Lozenge-shaped holes 13 are formed in the carrier 11 and are aligned with the centres of the diamond-shaped structures at the points of intersection between transverse axes 14, and a central longitudinal axis 15 of the carrier 11. The obtuse angles of the holes 13 have the same pitch Da. The terminals 12, extend from the carrier 11 at either side of each of the projections 16 and have the same pitch Da as shown in Fig. 2.

The terminal assembly as described can be used with connectors requiring a contact pitch of Da but the plan view of Fig. 3 shows the assembly adjusted to the terminal pitch Db. In order to increase the pitch between the terminals 12 from Da to Db, a substantially uniform compressive force is applied to the projections 16 and 17 by means of a simple device (not shown). In this manner the obtuse angles of the diamond-shaped structures are increased to tend to straighten the longitudinal sides of the diamond-shaped structures and close the lozenge-shaped holes 13. As a result, the pitch of respective contact terminals 12 is increased by ΔD from Da to Db.

The variations in the pitch of terminals 12 is directly related to the extent to which the obtuse angles forming the projections 16 and 17 are deformed. Let it be assumed that the symbol La represents the peripheral length of each lozenge-shaped hole 13, and that the symbol Lb denotes the length of the axial line 15 from one point of its bisection of an angle of a hole 13 to the other. Using these two symbols, the maximum value, ΔDmax, of adjustment factor ΔD can be represented as (La/2)-Lb. The pitch of the contact terminals 12 of the terminal assembly of Fig. 1 and 2 can thus be varied within the range of from Da to Da + ΔDmax dependent upon the extent to which the diamond-shaped structures are deformed. The terminal assembly embodying this invention can be adapted to suit various types of electrical connectors wherein the terminal pitch varies within the range between Da and Da + ΔDmax. There is moreover no need to separate the contact terminals 12 from the terminal carrier 11 in advance of setting them in the housing of a connector.

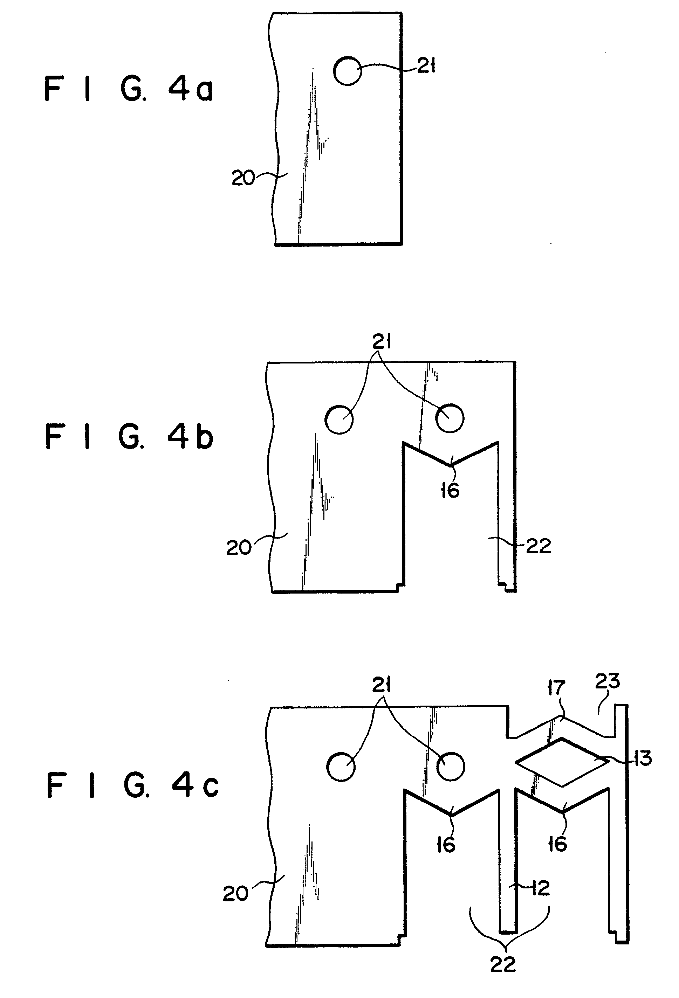

A method of manufacturing the terminal assembly will now be described with reference to Figs. 4a to 4c.

The leading end of a belt-like conductive metal plate 20 is fed into a progressive die (not shown) by a feeder (not shown) at the substantially constant prescribed pitch steps Da. In the first stage of the progressive die, pilot holes 21 are formed in one side margin of the plate 20, as shown in Fig. 4a. These pilot holes 21, spaced apart by Da, are used as a locating means to compensate for errors in the pitch at which the feeder carries plate 20 forward.

As shown in Fig. 4b, in the second stage of the progressive die, portions 22 of the metal plate 20, at one side of the pilot holes 21 are punched out in alignment with the pilot holes 21 to leave the contours of the first projections 16 and the contact terminals 12.

As shown in Fig. 4c, in the third stage of the progressive die, portions 23 of the plate 20 at the other side of the pilot holes 21 are punched out in alignment with the pilot holes 21 to define the projections 17 and the lozenge-shaped portions surrounding the pilot holes 21 are punched out of the metal plate 20 to provide the holes 13.

This invention is not limited to the embodiment described above and various modifications can be made. For instance, the shape of the through hole 13 need not be limited to that of a lozenge, but may, instead, be, for example, eliptical. It is preferred however that the width of each through hole 13 across the terminal carrier 11, be greatest near the central portion of the hole, that is the portion defined by the intersection of imaginary axes 14 and 15. Modifications to the shape of the sides of the device are also permissible. Rather than being angular, the sides could, for example, just as well be arcuate. The invention is also applicable to terminal assemblies for manufacturing not only electrical connectors but also IC pins (IC LEG), IC socket terminals and "Griplet" terminals (trademark of E I DU PONT DE NEMOURS AND COMPANY, U.S.A.),.

## Claims

1. A terminal assembly in the form of a conductive plate with an elongate terminal carrier (11) defined by a series of integral, shaped, apertured structures which provide a series of projections (16, 17) arranged at predetermined pitch therealong and a series of terminals (12) supported by the carrier (11) extending from either side of each of the projections (16) along one side of the terminal carrier (11), the terminals (12) having a pitch corresponding to that of the projections (16); characterized in that the plate is flat and the projections (16, 17) are composed of longitudinal sides of the structures which can be subjected to deformation force to cause the projections to move transversally of the carrier to alter the pitch of the terminals (12).

2. A terminal assembly according to claim 1, wherein the projections (16, 17) have the same shape and are symmetrical with respect to the longitudinal axis of said terminal carrier.

3. A terminal assembly according to claim 2, wherein the projections (16, 17) are also symmetrical with respect to transverse axes of the structures.

4. A terminal assembly according to claim 3, wherein the structures have through holes (13) which are symmetrical with respect to the longitudinal and transverse axes of the structures constituting the terminal carrier.

5. A terminal assembly according to claim 4, wherein the width of each through hole, transversely of the terminal carrier, is greatest near the central portion.

6. A terminal assembly according to claim 4 or 5, wherein each through hole (13) is lozenge-shaped.

7. A terminal assembly according to any one of claims 1 to 6, wherein the projections are angular.

8. A terminal assembly according to claim 1, wherein the structures are diamond shaped each with four equal sides and two obtuse angles between the sides which form the projections and lozenge shaped holes (13) are provided which are aligned with the centres of the diamond shaped structures and the deformation force closes the openings and lengthens the diamond shaped structures.

9. A method of assembling a multi-contact electrical connector, utilizing a terminal assembly in accordance with any one of the predetermined claims wherein the terminals have a predetermined pitch and the connector requires contacts with aa selectable pitch of at least Da or Db where Db > Da and comprising setting the terminals in a housing of the connector and thereafter separating the terminals from the carrier of the assembly; and adjusting the pitch of the terminals, if desired, from Da to Db by subjecting the projections (16, 17) of the carrier (11) to deformation force to cause the projections to move transversally of the carrier prior to setting the terminals in the housing.

10. A method of making a terminal assembly as claimed in claim 1 comprising feeding a conductive metal plate (20) longitudinally in steps of constant predetermined pitch (Da), forming pilot holes (21) in one side margin of the plate with the predetermined pitch (Da), cutting out portions (22) in the side margin of the plate opposite the holes (21) to define projections (16) along one edge of said side margin and terminals (12) disposed between the projections with the same predetermined pitch (Da) and cutting out further portions (13, 23) in the one side margin with the same predetermined pitch (Da) to provide further projections (17) along another edge of the side margin and to create a series of shaped structures defined by the projections (16, 17) which serve as a deformable carrier for the terminals.

## Revendications

1. Un ensemble de bornes sous la forme d'une plaque conductrice, comportant un support allongé pour bornes (11) défini par une série de structures d'un seul tenant conformées et présentant des ouvertures, qui procurent une série de saillies (16, 17) agencées le long du support selon un pas prédéterminé et une série de bornes (12) supportées par le support (11) et se prolongeant de chaque côté de chacune des saillies (16) le long d'un côté du support de borne (11), les bornes (12) présentant un pas correspondant à celui des saillies (16) ; caractérisé en ce que la plaque est plate et les saillies (16, 17) sont constituées par les côtés longitudinaux des structures qui peuvent être soumises à une force de déformation de façon à provoquer un déplacement des saillies transversalement au support de façon à modifier les pas des bornes (12).

2. Un ensemble de bornes selon la revendication 1, dans lequel les saillies (16, 17) présentent une même forme et sont symétriques par rapport à l'axe longitudinal dudit support de bornes.

3. Un ensemble de bornes selon la revendication 2, dans lequel les saillies (16, 17) sont également symétriques par rapport à des axes transversaux des structures.

4. Un ensemble de bornes selon la revendication 3, dans lequel les structures présentent des trous traversant (13) qui sont symétriques par rapport aux axes longitudinaux et transversaux des structures constituant le support de bornes.

5. Un ensemble de bornes selon la revendication 4, dans lequel la largeur de chaque trou traversant, transversalement au support de bornes, est plus importante au voisinage de la zone centrale.

6. Un ensemble de bornes selon la revendication 4 ou 5, dans lequel chaque trou traversant (13) est conformé en losange.

7. Un ensemble de bornes selon l'une quelconque des revendications 1 à 6, dans lequel les saillies sont angulaires.

8. Un ensemble de bornes selon la revendication 1, dans lequel les structures sont en forme de losange, chacune présentant quatre côtés égaux et deux angles obtus entre les côtés qui forment les saillies et des trous en forme de losange (13) étant prévus qui sont alignés avec les centres des structures en forme de losange, et dans lequel la force de déformation ferme les ouvertures et allonge les structures en forme de losange.

9. Un procédé d'assemblage d'un connecteur électrique multicontact utilisant un ensemble de bornes selon l'une quelconque des revendications précédentes, dans lequel les bornes présentent un pas prédéterminé et le connecteur exige des contacts présentant un pas susceptible d'être choisi à volonté d'au moins Da ou Db, où Db > Da, et dans lequel on monte des bornes dans un boîtier du connecteur après quoi on sépare les bornes du support de l'ensemble ; et l'on règle le cas échéant le pas des bornes, à partir de Da à Db, en soumettant les saillies (16, 17) du support (11) jusqu'à une force de déformation afin de provoquer un mouvement desdites saillies transversalement au support avant de monter les bornes dans le boîtier.

10. Un procédé de fabrication d'un ensemble de bornes tel que revendiqué dans la revendication 1, consistant à avancer longitudinalement une plaque de métal conducteur (20) selon des étapes de pas constant prédéterminé (Da), à former des trous de positionnement (21) dans une première bordure latérale de la plaque selon le pas prédéterminé (Da), à découper des parties (22) dans la bordure latérale de la plaque en regard des trous (21) afin de définir des saillies (16) le long d'un bord de ladite bordure latérale et des bornes (12) disposées entre les saillies avec le même pas prédéterminé (Da) et à découper d'autres parties (13, 23) dans ladite première bordure latérale selon le même pas prédéterminé (Da) afin de réaliser d'autres saillies (17) le long d'un autre bord de la bordure latérale et afin de réaliser une série de structures conformées définies par les saillies (16, 17) qui servent de support déformable pour les bornes.

**Patentansprüche**

1. Anschlußsystem in Form einer leitenden Platte mit einem länglichen Anschlußträger (11), der von einer Reihe von integralen, geformten, mit Öffnungen versehenen Gebilden gebildet wird, die eine Reihe von Vorsprüngen (16, 17) bereitstellen, die in vorbestimmten, regelmäßigen Abständen längs desselben angeordnet sind, und eine Reihe von Anschlüssen (12) bereitstellen, welche von dem Träger (11) getragen werden und von jeder Seite der jeweiligen Vorsprünge (16) längs einer Seite des Anschlußträgers (11) verlaufen, wobei die Anschlüsse (12) einen regelmäßigen Abstand haben, welcher jenem der Vorsprünge (16) entspricht, dadurch **gekennzeichnet,** daß die Platte flach ist und die Vorsprünge (16, 17) von den Längsseiten der Gebilden gebildet werden, welche einer Verformungskraft ausgesetzt werden können, um zu bewirken, daß die Vorsprünge sich in Querrichtung des Trägers zur Änderung des regelmäßigen Abstandes der Anschlüsse (12) bewegen.

2. Anschlußsystem nach Anspruch 1, bei dem die Vorsprünge (16, 17) die gleiche Gestalt haben und symmetrisch bezüglich der Längsachse des Anschlußträgers vorgesehen sind.

3. Anschlußsystem nach Anspruch 2, bei dem die Vorsprünge (16, 17) auch symmetrisch bezüglich der Querachsen der Gebilde sind.

4. Anschlußsystem nach Anspruch 3, bei dem die Gebilde Durchgangsöffnungen (13) haben, welche symmetrisch bezüglich der Längs- und Querachsen der Gebilde sind, welche den Anschlußträger bilden.

5. Anschlußsystem nach Anspruch 4, bei dem die Breite jeder Durchgangsöffnung in Querrichtung des Trägers in der Nähe des Mittelteils am größten ist.

6. Anschlußsystem nach Anspruch 4 oder 5, bei dem jede Durchgangsöffnung (13) rhombusförmig ausgebildet ist.

7. Anschlußsystem nach einem der Ansprüche 1 bis 6, bei dem die Vorsprünge winkelig ausgebildet sind.

8. Anschlußsystem nach Anspruch 1, bei dem die Gebilde rautenförmig ausgebildet sind und jeweils vier gleiche Seiten und zwei stumpfe Winkel zwischen den Seiten haben, welche die Vorsprünge bilden, und daß die rhombusförmigen Öffnungen (13) derart vorgesehen sind, daß sie zu den Mittelteilen der rautenförmig ausgebildeten Gebilde ausgerichtet sind und die Verformungskraft die Öffnungen schließt und die rautenförmigen Gebilde in die Länge streckt.

9. Verfahren zum Anschließen eines elektrischen Verbinders mit einer Vielzahl von Kontakten unter Verwendung eines Anschlußsystems nach einem der vorangehenden Ansprüche, bei dem die Anschlüsse einen vorbestimmten regelmäßigen Abstand haben und der Verbinder Kontakte mit einem wählbaren regelmäßigen Abstand von wenigstens Da oder Db haben, wobei Db > Da ist, und bei dem die Anschlüsse in ein Gehäuse des Verbinders eingesetzt und anschließend die Anschlüsse von dem Träger des Systems getrennt werden, und bei dem der regelmäßige Abstand der Anschlüsse gegebenenfalls von Da zu Db dadurch verändert wird, daß die Vorsprünge (16, 17) des Trägers (11) einer Verformungskraft ausgesetzt werden, um zu bewirken, daß die Vorsprünge sich in Querrichtung des Trägers vor dem Einsetzen der Anschlüsse in das Gehäuse bewegen.

10. Verfahren zum Herstellen eines Anschlußsystems, bei welchem eine leitende Metallplatte (20) in Schritten mit einem konstanten, vorbestimmten, regelmäßigen Abstand Da vorgeschoben wird, Führungsöffnungen (21) in einem Seitenrand der Platte mit einem vorbestimmten regelmäßigen Abstand Da ausgebildet werden, Teile (22) im Seitenrand der Platte den Öffnungen (21) gegenüberliegend ausgeschnitten werden, um Vorsprünge (16) längs eines Randes des Seitenrandes und Anschlüsse (12) auszubilden, die zwischen den Vorsprüngen mit ein- und demselben, vorbestimmten, regelmäßigen Abstand Da angeordnet sind, und bei dem weitere Teile (13, 23) in einem Seitenrand mit ein- und demselben, vorbestimmten, regelmäßigen Abstand Da ausgeschnitten werden, um weitere Vorsprünge (17) längs des anderen Randes des Seitenrandes zu erhalten und eine Reihe von ausgeformten Gebilden zu erzeugen, die durch die Vorsprünge (16, 17) begrenzt werden, welche als ein verformbarer Träger für die Anschlüsse dienen.

# F I G. 1

# F I G. 2

# F I G. 3

F I G. 4a

20

21

F I G. 4b

21

20

16

22

F I G. 4c

21

17   23

13

20

16   16

12

22